(19) Europäisches Patentamt / European Patent Office / Office européen des brevets

(11) **EP 1 719 394 B1**

(12) **EUROPEAN PATENT SPECIFICATION**

(45) Date of publication and mention
of the grant of the patent:
**09.07.2008 Bulletin 2008/28**

(51) Int Cl.:
***H05K 3/12*** *(2006.01)*

(21) Application number: **05708334.7**

(22) Date of filing: **14.02.2005**

(86) International application number:
**PCT/GB2005/000515**

(87) International publication number:
**WO 2005/081597 (01.09.2005 Gazette 2005/35)**

(54) **METHODS OF FORMING TRACKS AND TRACK ARRANGEMENTS**

VERFAHREN ZUR BILDUNG VON SPUREN UND SPURENANORDNUNGEN

PROCEDES POUR FORMER DES TRACES ET DES SYSTEMES DE TRACES

(84) Designated Contracting States:
**AT BE BG CH CY CZ DE DK EE ES FI FR GB GR
HU IE IS IT LI LT LU MC NL PL PT RO SE SI SK TR**

(30) Priority: **13.02.2004 GB 0403234**

(43) Date of publication of application:
**08.11.2006 Bulletin 2006/45**

(73) Proprietor: **Xaar Technology Limited
Cambridge, Cambridgeshire CB4 OXR (GB)**

(72) Inventors:
• **DRURY, Paul, Raymond
Royston,
Hertfordshire SG8 8ST (GB)**

• **TEMPLE, Stephen
Impington,
Cambridge CB4 9NU (GB)**

(74) Representative: **Garratt, Peter Douglas et al
Mathys & Squire LLP
120 Holborn
London EC1N 2SQ (GB)**

(56) References cited:
**EP-A- 0 417 294       US-A1- 2003 198 789**

**Description**

This invention relates to the formation of printed circuit board tracks (and other tracks required to have defined electrical or mechanical properties) by the deposition of liquid to form dots on a substrate.

Ink jet printing is a well-known technique for printing an image by the deposition of liquid to form dots on substrate. It has also been proposed to print circuit boards using an ink jet printing technique with conductive inks.

For printed circuit boards, there is a requirement for the accurate placement of conducting tracks at a range of widths and at a range of directions. One critical factor is the minimum separation that can be defined between adjacent tracks without risk of short-circuiting. Another critical factor is the minimum track width. With "conventional" photolithographic printed circuit board techniques, the formation of these closely spaced tracks with clearly defined straight edges, is generally not a difficulty. The conventional techniques are however expensive and time consuming, typically because of the multiple process steps that are required for each board layer. Ink jet printing offers faster and less expensive processing techniques. However, ink jet printing carries the fundamental limitation that all tracks have to be formed from circular dots at a characteristic nozzle spacing. (It is recognised that in "multi-pass" ink jet printing, dots can be formed more closely together than the characteristic nozzle spacing, by the number of passes.) Taking the simplest case of a track extending vertically (at right angles to the nozzle array), it will be clearly seen that the precision with which a desired track edge location can be addressed is restricted by the characteristic nozzle spacing s. Similarly, there are fundamental restrictions on the smoothness of the edge that can be formed and the minimum separation that can be established between adjacent tracks, without risk of short-circuit. Of course, a printed circuit board technology, should be able to form tracks at a wide range of angles or directions and not simply vertically. This presents real difficulties for ink jet printing techniques where parameters such as the smoothness of a track edge will vary widely depending upon whether that edge is parallel to the grid (defined by the nozzle array and the direction of substrate scanning) or at an arbitrary angle to that grid.

Some consideration has been given in the ink jet printing of images, to enhancing the edges of typographical characters and the like. There is now a reasonable understanding of how the human eye sees "straight" edges that are in fact made up from lines of closely spaced dots. This understanding cannot, however, be transferred to printed circuit board technology since what matters with printed circuit boards is not how straight an edge might be perceived by the human eye but what is the conductivity along an intended track direction and what is the insulation between neighbouring tracks to guard against short-circuit. To give one brief example, one technique in the ink jet printing of images is to form dots that are significantly smaller than the characteristic nozzles spacing s so as to increase the straightness of a perceived edge. In the printing of images, it is of course immaterial whether the small dots physically touch or overlap. With ink jet printing of circuit boards a "perceived" increase in the straightness of a track will be useless unless the dots of ink overlap in the track which is electrically conductive and are kept as far as possible away from the dots which form adjacent, isolated tracks.

It is an object of certain aspects of this invention to provide improved methods and arrangements for forming tracks having defined electrical or mechanical properties, by the deposition of liquid to form dots on a substrate which enable tracks to be formed at a given nozzle spacing with increased precision of track placement.

Accordingly the present invention consists in one aspect in a method of forming an arrangement of tracks having defined electrical or mechanical properties, by the deposition of liquid to form dots on a substrate from nozzles mutually spaced by a distance s; the method comprising the steps of defining a set of n dot diameters $D_i = 2s(1/2 + i/n)$, where i is a running integer from 0 to (n-1); depositing liquid to form linear tracks at one or more directions with respect to an axis X; each track having a minimum track width $T_w = s(3n-2)/n$; and the minimum spacing of tracks along the axis X being $T_s = s/n$. In a preferred example, the dot diameters: s, 1.5s, 2s and 2.5s are employed.

By choosing dot diameters $D_i = 2s(1/2 + i/n)$, it is arranged that a track edge can be located to within s/n of any desired location.

In another aspect, the present invention consists in an arrangement of tracks having defined electrical or mechanical properties formed by the deposition of liquid to form dots on a substrate at a regular array of deposition locations mutually spaced by a distance s, the dots having a set of n dot diameters $D_i = 2s(1/2 + i/n)$, where i is a running integer from 0 to (n-1); the arrangement comprising linear tracks orientated at orientations with respect to an axis X, at least one track having a track width $T_w = s(3n-2)/n$; and at least two tracks having a mutual spacing $T_s$ along the axis X of $T_s = s/n$. In a preferred example, the dot diameters: s, 1.5s, 2s and 2.5s are employed.

In still another aspect, the present invention consists in a method of forming a linear track having defined electrical or mechanical properties by the deposition of liquid to form dots on a substrate from nozzles mutually spaced by a distance s, the track being inclined to an axis X; the method comprising the steps of defining a set of at least three dot diameters $D_i$ where the smallest dot diameter $D_{min}$ s and the largest diameter $D_{max}$ 3s ; and repeatedly forming a dot pattern comprising at least three dots in a line parallel to the axis X, the first and third of these dots being of diameters which are equal and which are less than the diameter of the second dot, each succeeding repetition of the dot pattern being offset from the preceding pattern a distance s in the direction orthogonal to the direction X and a distance equal to or greater than s in the direction X.

Preferably, the set comprises n dot diameters $D_i = 2s(1/2 + i/n)$, where i is a running integer from 0 to (n-1).

Advantageously, the dot pattern takes the form at one angle of:

$$D_0, D_1, D_2, ... D_1, ... D_{n-1} .... D_i, ... D_2, D_1, D_0$$

with dots in the pattern being progressively removed for increasing angles and dots in the pattern being progressively repeated for decreasing angles.

In still another aspect, the present invention consists in a linear track having defined electrical or mechanical properties formed by the deposition of liquid to form dots on a substrate at a regular array of deposition locations mutually spaced by a distance s, the track being inclined to an axis X; the track comprising a repeated dot pattern comprising at least three dots in a line parallel to the axis X, the first and third of these dots being of diameters which are equal and which are less than the diameter of the second dot, each succeeding repetition of the dot pattern being offset from the preceding pattern a distance s in the direction orthogonal to the direction X and a distance equal to or greater than s in the direction X.

Preferably, the set comprises n dot diameters $D_i = 2s(1/2 + i/n)$, where i is a running integer from 0 to (n-1).

Advantageously, the dot pattern takes the form at one angle of:

$$D_0, D_1, D_2, ... D_i , ... D_{n-1}, ... D_i, ... D_2, D_1, D_0$$

with dots in the pattern being progressively removed for increasing angles and dots in the pattern being progressively repeated for decreasing angles.

In yet another aspect, the present invention consists in a substrate having formed thereon at least one track having defined electrical or mechanical properties formed by the deposition of liquid to form dots on a substrate at a regular array of deposition locations mutually spaced by a distance s, the track having an edge being inclined to an axis X; the track edge comprising a repeated dot pattern comprising at least three dots in a line parallel to the axis X, the diameters of the dots increasing along the line, each succeeding repetition of the dot pattern being offset from the preceding pattern a distance s in the direction orthogonal to the direction X and a distance equal to or greater than s in the direction X.

In still another aspect, the present invention consists in a method of defining a gap between two planar structures having defined electrical or mechanical properties by the deposition of liquid to form dots on a substrate at a regular array of deposition locations mutually spaced by a distance s, parallel to an axis X; the method comprising the steps of defining a set of n dot diameters $D_i = 2s(1/2 + i/n)$, where i is a running integer from 0 to (n-1); forming pairs of dots at respective sides of the gap at locations spaced by 2s; the sum of the diameters of the pair of dots equalling 2s(2n-1)/n.

In still another aspect, the present invention consists in a method of forming a track, said method comprising the steps: assigning a grid of addressable pixels to a substrate, said grid having a predetermined spacing s, where s is a distance; selecting for each pixel a dot of one of n predetermined sizes, wherein n is an integer greater than 2; forming the dots on the substrate and thereby forming the track; wherein at least one of the predetermined sizes of dots has a diameter greater than s 2.

Preferably, the diameter is not less than 2s, and the predetermined size of a dot for each pixel is selected such that a straight-line track edge is approximated by said dots to within s/n.

In still another aspect, the present invention consists in a method of approximating a straight track edge on a substrate, said track edge being approximated by a plurality of dots, each dot having one of n diameters, where n is greater than 2; said method comprising the steps: assigning a grid of addressable pixels to a substrate, said grid having a predetermined spacing s; calculating the position of said profile with respect to said addressable pixels; determining for each addressable pixel whether a portion of profile adjacent or within a pixel would be better approximated by a dot in said pixel or by a dot in a neighbouring pixel; and displaying a dot in said determined pixel.

Preferably, at least one of the n diameters of dots is greater than s 2 and more preferably not less than 2s.

Advantageously, at least one dot is displayed in a neighbouring pixel which is not an adjacent pixel.

In still another aspect, the present invention consists in a track arrangement on a substrate, said arrangement comprising two groups of dots, said dots being arranged in a plurality of addressable pixels, the addressable pixels have an inter dot spacing, measured from the centre of a pixel to the centre of an adjacent pixel of s; wherein the dots of each group overlap and each dot has one of n diameters, wherein n is an integer greater than 2 ; wherein each group has an edge approximated by said dots; wherein the distance between the two edges is of the order s/n.

The present invention will now be described, by way of example only, with reference to the following drawings in which:

Figure 1 depicts an angled track printed with a conventional binary printhead.

Figure 2 depicts a track printed in a conventional greyscale method.

Figure 3 depicts a track printed according to the present invention.

Figure 4 depicts another track printed according to the present invention.

Figure 5 depicts tracks at four different angles with a first drop set.

Figure 6 depicts tracks at three different angles with a second drop set.

Figure 7 depicts a further track printed according to the present invention.

Figure 8a-d depicts a corner printed according in a binary scheme.

Figures 9 to 11 depict addressable edges achievable according to a printing scheme according to the present invention.

Figure 12a to 12c shows how an error may be minimised.

Figure 13 depict the range of dots that may be produced with 16 grey levels

Figure 14 depicts a two-pixel width track according to the present invention.

Figure 15 is an image of a track printed in a binary scheme.

Figure 16 and Figure 17 are images of tracks printed according to the present invention.

Figure 18 depicts the formation of an gap of minimum width and arbitrary form, according to this invention

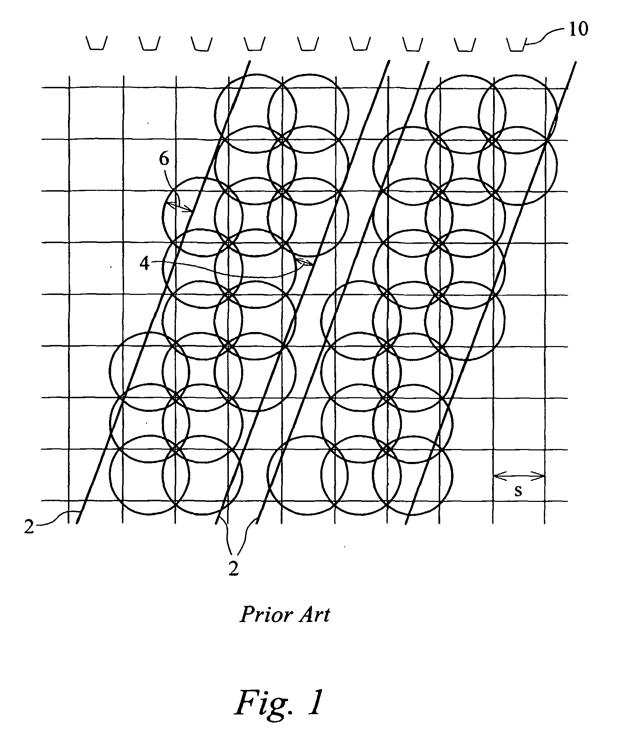

Referring initially to Figure 1, there is shown a conventional ink jet printing technique for forming tracks using "binary" printing, that is to say with a single dot diameter. Droplets of liquid are deposited from nozzles 10 using any appropriate ink jet printing technology. These nozzles 10 are spaced at a distance s and the dots formed by the ejected ink droplets lie on a rectangular grid having a spacing s in the direction along the nozzle array and a dimension in the orthogonal direction which is determined by the rate of scanning of the substrate past the nozzle array and the frequency of droplet ejection. This dimension may typically also be s. It will be understood that dots can be formed at a spacing which is less than the nozzle spacing s in the direction of the nozzle array with multiple passes of the nozzle array over the substrate.

In this arrangement, each dot is of a uniform size equal to s 2. Each dot overlaps the edge of adjacent pixel by distance which is equal to (s 2-s). The intended edges of the tracks in Figure 1 are shown by lines 2. It will be seen that at some points (for example those marked at 4 and 6) approximation to the line 2 is poor. However, no greater accuracy is possible in a single pass operation at a given value s. Looked at another way, the width of the track varies considerably with the track being at some point two dots wide and at other points three points wide. For the very narrow tracks increasingly required in the fabrication of electronic circuitry, this variation in track width leads to an unacceptable increase in resistance and high frequency emissions. It will also be apparent that the minimum inter-track spacing is equal to (s-2 (s 2-s)),. At most points along the tracks, however, the inter-track spacing is significantly greater. This will not generally give the required efficiency in circuit board utilisation.

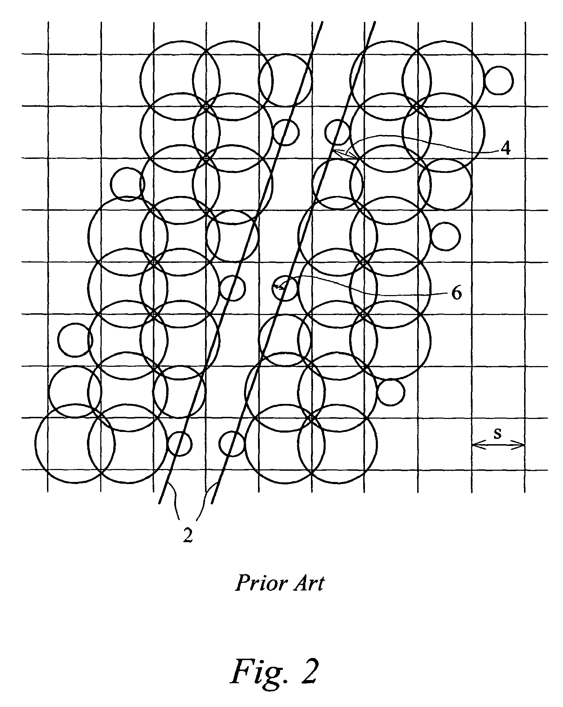

Figure 2 illustrates a prior art attempt to print the same tracks, now with a number of different dot diameters in "grey scale" printing. In a typical arrangement the largest dot diameter corresponds to the dot diameter s 2 of the binary system illustrated in Figure 1, but a number of smaller dot diameters are provided, in this case two such smaller dot diameters. With a printed image, the grey scale approach would be expected to produce a significantly straighter perceived edge. In the present situation, however, it will be seen that the smallest dot size when placed along the edge of the track to improve the perceived straightness, actually has very little effect upon the conductivity of the track since each of these smallest dot sizes typically abuts only one of the neighbouring dots.

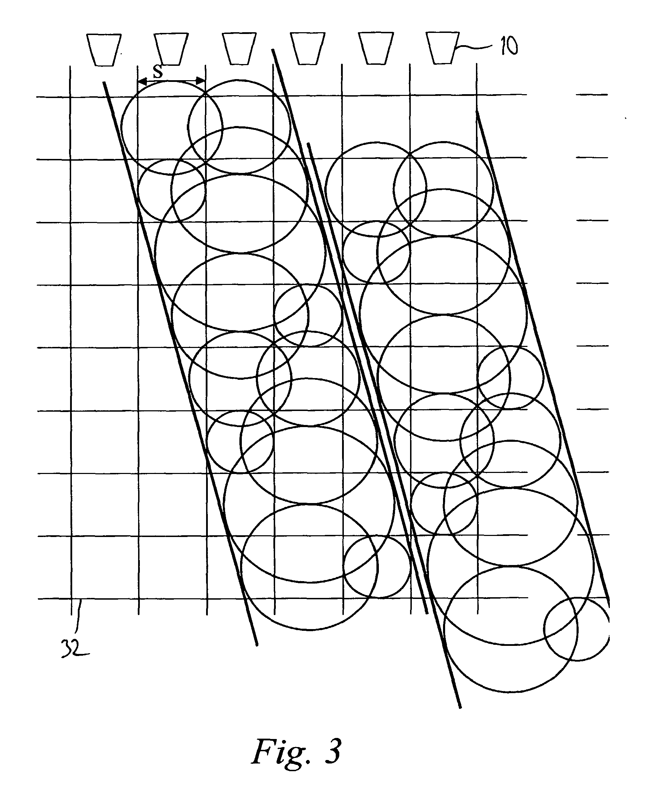

An arrangement according to the present invention will now be described with reference to Figure 3. As with the previous figures, nozzles 10 are illustrated schematically at a nozzle spacing s, this spacing defining a grid 32 with reference to the substrate. This grid is depicted as square although it will be understood that the dimension in the direction orthogonal to the nozzle array (that is to say the vertical dimension in the drawing) need not necessarily be equal to s. In the arrangement of Figure 3, four dot diameters D are employed. Each dot is centred on a grid square, the smallest dot diameter D being set equal to s. The next size dot diameter is chosen so that the circumference of the dot overlaps the adjacent grid squares by up to one quarter of the width of that grid square. That is to say, the next dot diameter is chosen so that $D_2 = 1.5s$. Similarly, the remaining dots are chosen so as to overlap by 50% and 75% respectively the adjacent grid squares, taking values $D_3 = 2s$ and $D_4 = 2.5s$. Generalising to a value n of dot diameters, it will be seen that these dot diameters Dl are given by:

$$D_i = 2s(1/2 + i/n),$$

where i is a running integer from 0 to (n-1)

The dot patterns which are used to form the narrow, closely spaced tracks are highly ordered. It will be seen that the pattern of dots produced by the droplets from a single nozzle (that is to say a vertical column in the representation of Figure 3) form an ascending sequence $D_1$, $D_2$, $D_3$, $D_4$ and a descending sequence $D_4$, $D_3$, $D_2$, $D_1$. This ascending and descending sequence from the smallest dot diameter to the largest dot diameter and back to the smallest dot diameter has particular preferred characteristics in the ability to form narrow closely spaced tracks over a range of angles (with respect to the grid axis).

This explanation concentrates on the minimum track width for the reason that it is straightforward to produce tracks of larger width. Such larger track widths can be formed by repeating the characteristic dot patterns shown in Figure 3. In certain cases, and typically with larger track areas, it will be appropriate to use the characteristic dot patterns shown in Figure 3 at the edges of the wide track with possibly other dot patterns in the centre of the track region. Those other dot patterns may be chosen to optimise efficiency of area coverage. The minimum track width achievable with the arrangement of Figure 3 at an arbitrary angle is:

$$T_w = s(3n-2)/n$$

At an arbitrary angle, the preferred arrangement guarantees a minimum spacing of tracks parallel to the grid axis of $s/n$ (with $s$ being replaced by the other grid dimension if a non-squared grid is employed).

The grid depicted in the figures is at a spacing of 360dpi i.e. the centre of each dot is approximately 70$\mu$m apart in each axis. This equates to distance $s$. The shown grid could, however, be 720, 1440 or 2880dpi or some other resolution. The dots are deposited by an inkjet print head into the centre of each of the addressable pixels.

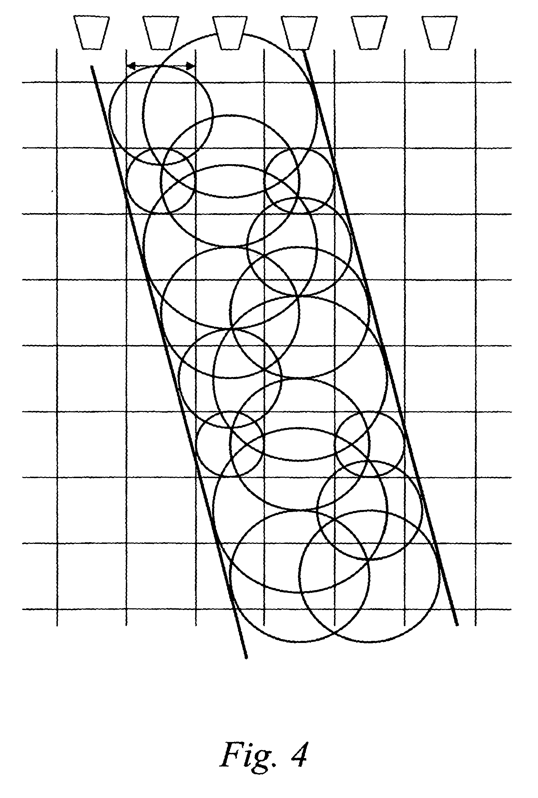

The arrangement depicted in Figure 4 produces an increased track width. It will be seen that in this case, the ascending and descending sequences of dot diameters $D_1$, $D_2$, $D_3$, $D_4$, still define the track edge, but instead of inserting an increased diameter $D_5$ in the sequence, the "central" diameter in the sequence is $D_4$ with the increased track width arising from the appearance in the same row of the grid of a dot diameter $D_1$ from the "end" of a sequence in the left-hand neighbouring column and a dot diameter $D_1$ at the "beginning" of a sequence in the right-hand grid column. This approach can be extended by replacing the dot at the centre of the ascending and descending sequence by a dot of diameter $D_2$, this dot then cooperating with equal size dots in the left-hand and right-hand neighbouring grid columns to form an incrementally wider track.

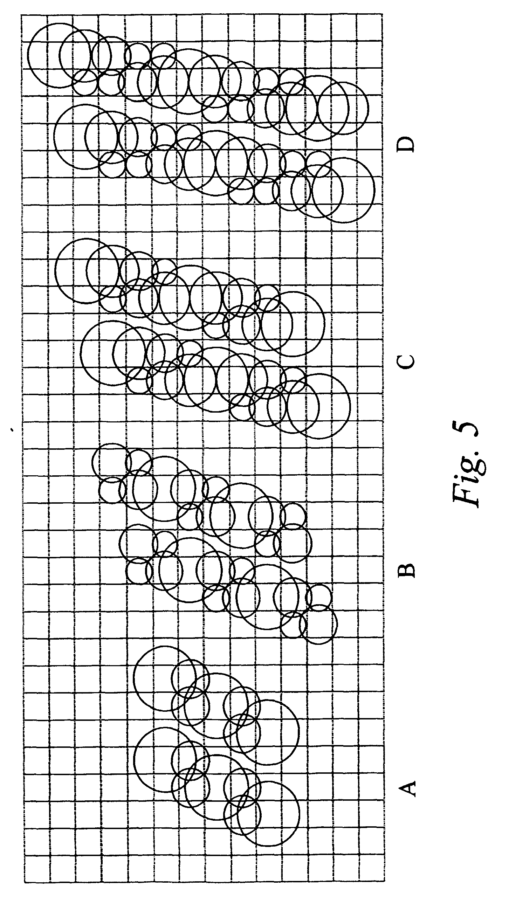

Figure 5 illustrates tracks formed at four different angles. In each case n=4 and the drop diameters are:

$D_0$ = 1.0s
$D_1$ = 1.5s
$D_2$ = 2.0s
$D_3$ = 2.5s

Figure 5 shows (at A) parallel tracks having a width 2.5s at an angle arctan 2. It will be seen that the tracks are formed from the repeating drop pattern $D_1$, $D_3$, $D_1$ with each repeat of the pattern being offset a distance $s$ horizontally (in the drawing) and a distance $2s$ (thus giving arctan 2) vertically.

At (B), an arrangement is shown with the repeating pattern $D_0$, $D_1$, $D_3$, $D_1$, $D_0$ offset a distance $s$ horizontally (in the drawing) and a distance $3s$ vertically, providing a track angle of arctan 3. It is important to note that this different angle is achieved without a change in track width.

At (C), an arrangement is shown with the repeating pattern $D_0$, $D_1$, $D_2$, $D_3$, $D_2$, $D_1$, $D_0$ offset a distance $s$ horizontally (in the drawing) and a distance $4s$ vertically, providing a track angle of arctan 4. Again, that this different angle is achieved without a change in track width.

The diagrams (A), (B) and (C) illustrate examples of the pattern:

$D_0$, $D_1$, $D_2$, ... $D_i$, ...$D_{n-1}$, ... $D_i$, ...$D_2$, $D_1$, $D_0$

with dots in the pattern being progressively removed for increasing angles from (C) to (A). To decrease the angle from that of (C), dots in the pattern can be repeated. Thus Figure 5 shows at (D) the repeating pattern $D_0$, $D_0$, $D_1$, $D_2$, $D_3$, $D_2$, $D_1$, $D_0$, $D_0$ to provide an angle of arctan 5.

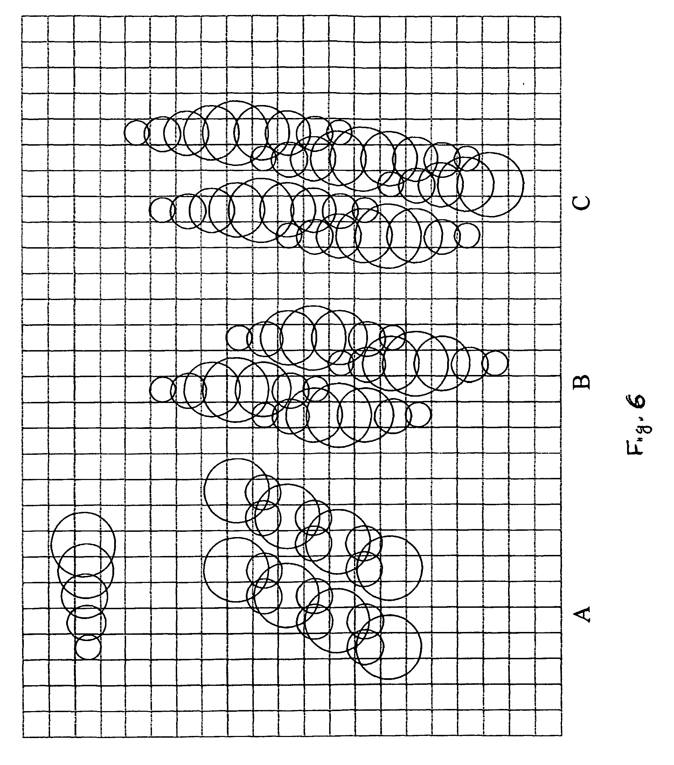

Figure 6 shows at (A), (B) and (C) tracks of minimum width 2.6s with five dot sizes:

$D_0$ = s
$D_1$ = 1.4s
$D_2$ = 1.8s
$D_3$ = 2.2s
$D_4$ = 2.6s

At (A), tracks are shown formed from the repeating drop pattern $D_1$, $D_4$, $D_1$ with each repeat of the pattern being offset a distance s horizontally 2s vertically.

At (B), an arrangement is shown with the repeating pattern $D_0$, $D_1$, $D_3$, $D_4$, $D_3$, $D_1$, $D_0$ offset a distance 4s vertically, providing a track angle of arctan 4.

At (C), an arrangement is shown with the repeating pattern $D_0$, $D_1$, $D_2$, $D_3$, $D_4$, $D_3$, $D_2$, $D_1$, $D_0$ offset a distance 5s vertically, providing a track angle of arctan 5. Again, note that these different angles are achieved without a change in track width. Similarly, angles can be increased or decreased by omitting or repeating drops in the repeating pattern.

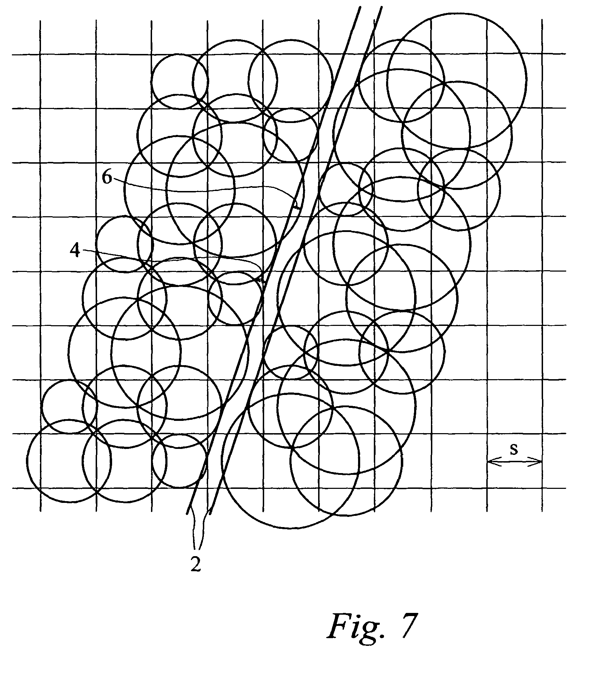

A further embodiment of the invention is illustrated at Figure 7. The tracks may be formed in a single pass of the print head as a single dot is displayed in each addressable pixel. One of a number of predetermined dot sizes may be displayed in a respective pixel. In contrast to the conventional greyscale at least one, and preferably two or more of the predetermined dots have a diameter that is greater than s 2. The dots shown have diameters on the substrate that increase by a substantially regular amount i.e. s, 1.5s, 2s and 2.5s.

Using the above dot sizes enables the addressability of an edge to within s/n and therefore the approximation of a desired track edge location to within s/n. As can be seen from Figure 7, this ability to address an edge enables the tracks to be spaced with a smaller inter-track spacing than with a binary or conventional greyscale display that is equal, in the smallest case, to s/n.

Where a track is provided that has two parallel edges it is preferred in this embodiment that the edges are spaced at least 3s apart. This ensures that both edges can be approximated by respective dots to similar degrees of accuracy.

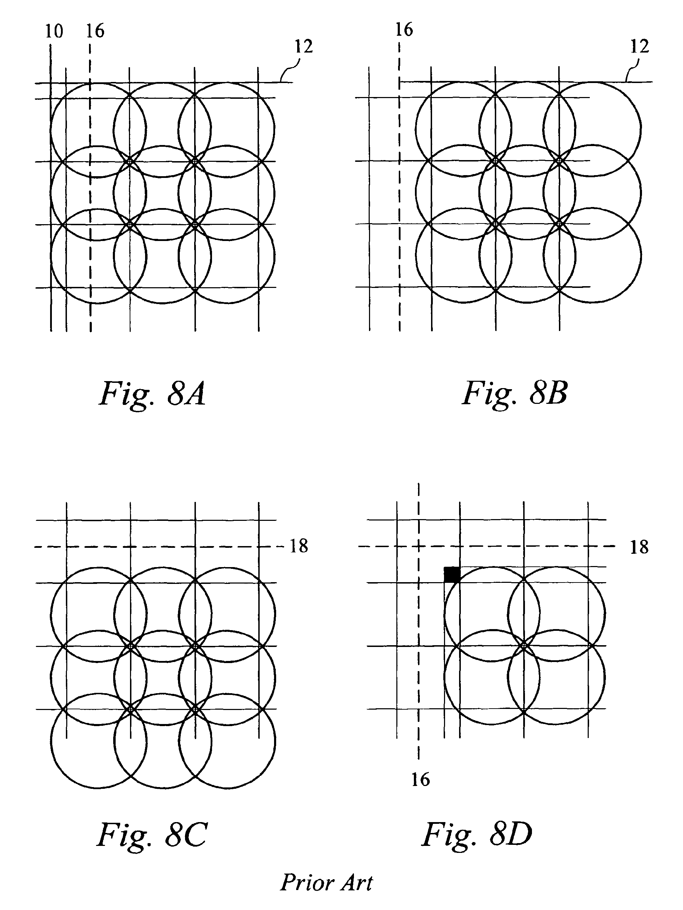

The addressability of a row of dots to an edge will be described in greater detail with respect to Figure 8 to Figure 11. These figures show a corner printed first in binary, Figure 8, and secondly with the multiple dot sizes according to the present invention. All the figures are displayed at the same pixel grid addressability.

For the binary (prior art) print of Figure 8a to d, where a single dot size is displayed, it is clear that an edge 10, 12 may be addressed to a single point in the pixel. Thus, for example, if an edge is required to be addressed at a point equal to x% across a pixel, as shown by hatched line 16, the error is equal to-((x/100.s)-(s-s 2)) or + (s 2-(x/100.s)). Clearly, at certain values of X, for example 80% the error is quite large either -0.38s or +0.61 s. This places significant constraints on image quality and the location of the edge.

For a conventional greyscale image, where a plurality of dots smaller than the size of the grid spacing s is used, and the dots are displayed at the centre of the each of the addressable pixels, the maximum error is given by the equation:

$$+/-\ ½((1/2s + rsd/100.s) – (rld/100.s – s))$$

where rsd is the radius of the smallest drop and rld is the radius of the largest drop as percentages of s.

For the situation where the radius of the largest drop is 1.4s i.e. rld=140% of s and the radius of the smallest drop is 0.2s i.e. 20% of s, the maximum error displayed is equal to +/- 0.15s i.e. 15% of s. This maximum error would be the same regardless of the number of grey levels used between the largest and smallest drops.

It will be apparent that there is a natural limitation to the minimum drop volume that may be ejected since as the volume decreases the relative air drag increases to a point that an unachievable velocity is required from the print head to ensure the droplet reaches the substrate. The current limit on the smallest drop volume would be around 2pl, which would provide a dot size of the order 23 $\mu$m on the substrate. This, for a 70 $\mu$m grid spacing, equates to just over 30% of the grid.

It is important to remember that for a displayed image, where there is no requirement for dots to touch, it may be acceptable to use the smaller dot sizes. Where the dots conduct electricity it will be apparent that the smallest dot in the above example will only touch a neighbouring dot in one axis leading to a higher resistance in the image, as described with reference to Figure 2.

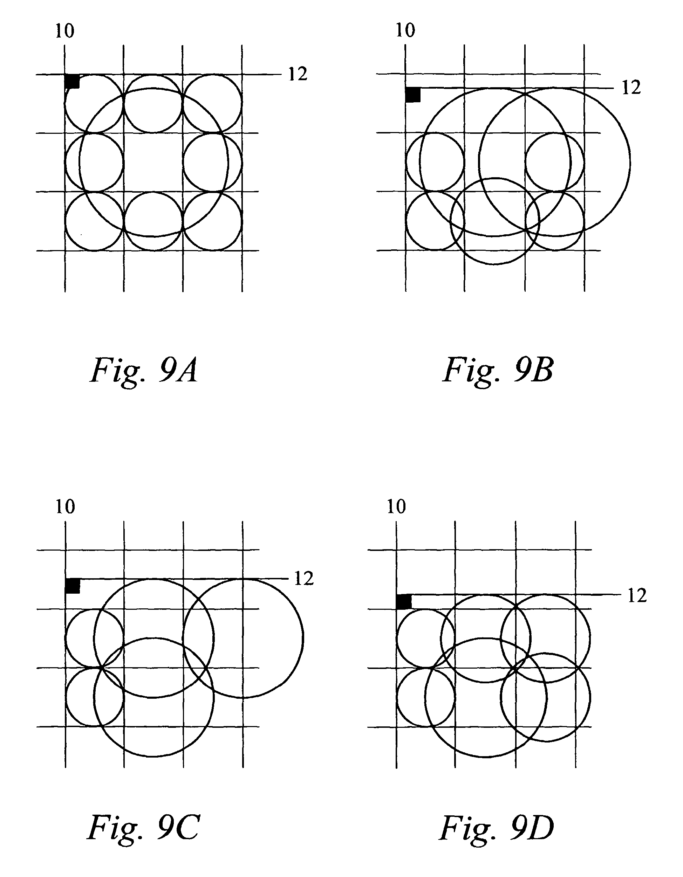

An aspect of the present invention will now be further described with reference to Figures 9 to 11. Figure 9a to d depicts an track edge having a line 10 approximated by dots and a second line 12 similarly approximated by dots. The first profile 10 is fixed with respect to the pixel grid and the second profile 12 is varied in accordance with a desired edge addressability. As can be seen, where each dot has a regular increase in size over a smaller dot and where the smallest dot has a diameter equal to s, and the largest diameter is equal to 2.6s then the profile 12 may be addressed to within s/n, where n in this case is 3. The maximum error is therefore ½ s/n.

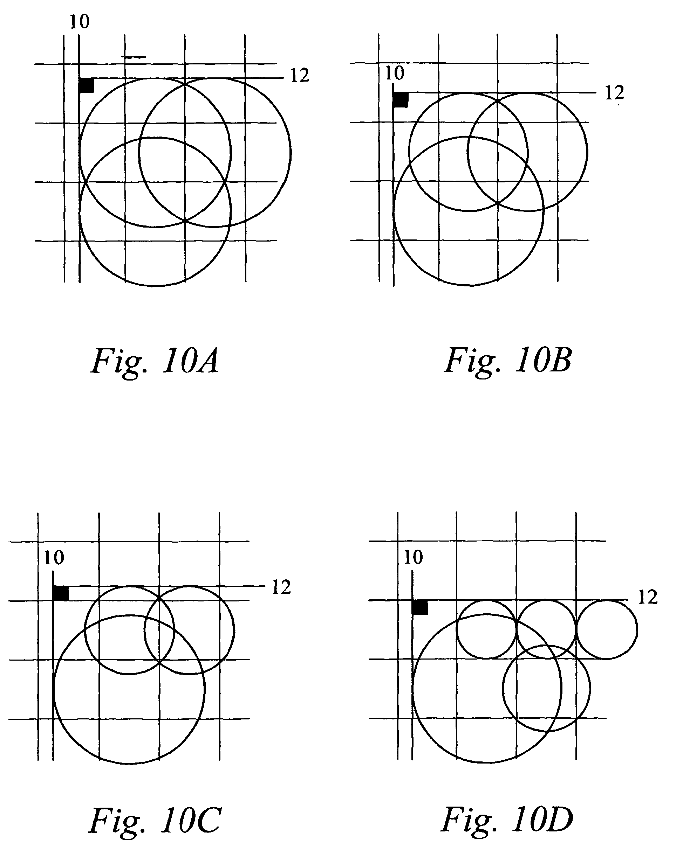

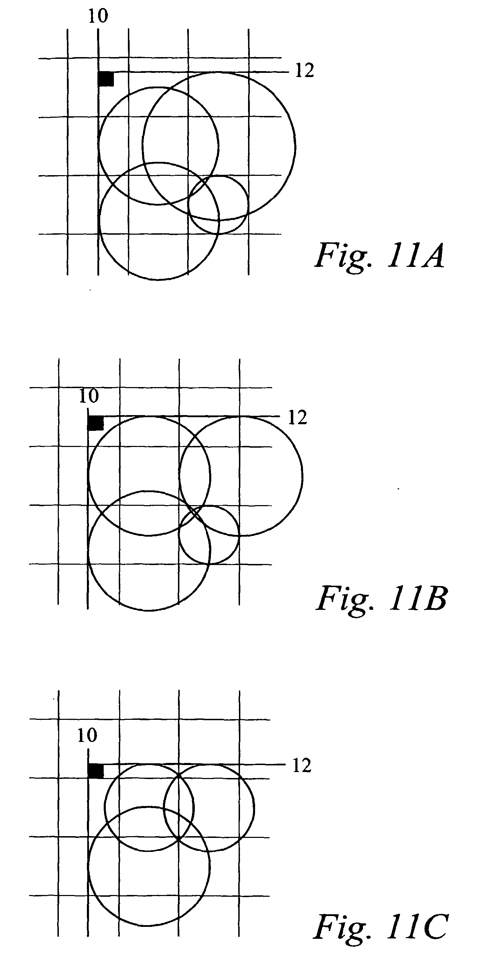

The addressability of profile 10 may similarly be defined to within a distance of s/n as depicted self evident manner in Figures 10 and 11.

By adding in further predetermined dot sizes at a regular increase in size it is possible to further improve the edge addressability. There is fundamentally no inherent limitation to the edge addressability that may be achieved.

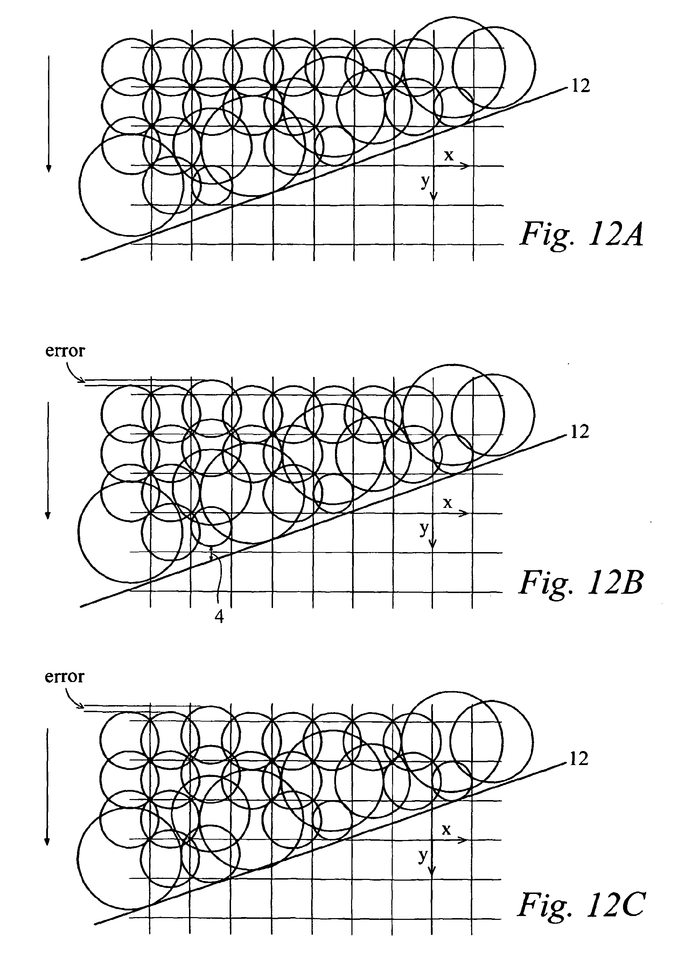

A further advantage of the present invention lies in the ability to compensate for drop landing or other dot positioning errors. Figure 12a depicts track having an inclined track edge 2. Each dot is perfectly centred on the grid and can accurately approximate the smoothed profile 2 using 3 different drop sizes. In Figure 12b, one of the dots formed by the print head has an error in the Y or scanning direction. If the same algorithm is used to produce the image as used to form the image of Figure 12b, then the line 2 does not produce the best fit.

In single pass printing, where each column is produced by a single dot generating element it is possible to modify the algorithm such that the dot size produced by the dot generating element is modified either to increase or reduce the size of the dot such that the profile is better approximated, as depicted in Figure 12c. The change may be permanent in that it is applied to every future image or may be varied on an image by image basis.

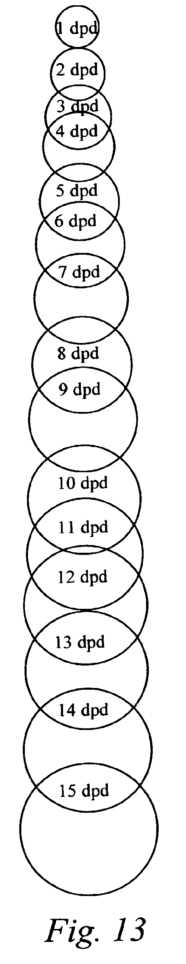

It is also think of arrangements according to the present invention serving to shift the "centre of gravity" of a track by modifying the weighting of dots used to form the track. Using a print head, commercially available from Xaar under the trade name "LEOPARD" it is possible to print fifteen different sizes of drop as depicted in Figure 13, the typical diameters of the dots are given in the table below.

| Number of sub-droplets per dot (dpd) | Typical diameter ($\mu$m) |
| --- | --- |
| 1 | 39 |
| 2 | 55 |
| 3 | 68 |
| 4 | 78 |
| 5 | 87 |
| 6 | 96 |
| 7 | 103 |
| 8 | 110 |
| 9 | 117 |
| 10 | 124 |
| 11 | 130 |
| 12 | 135 |
| 13 | 141 |
| 14 | 146 |
| 15 | 151 |

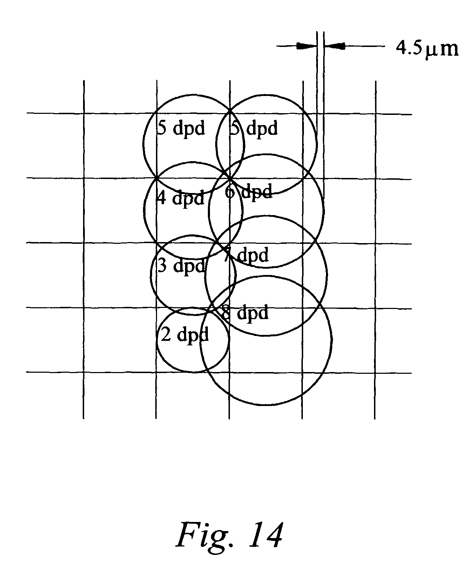

In Figure 14, the dot sizes can be used to generate very slight angles to a track. These angles can be modified in succession, thereby producing accurate and smooth curves, which can maximise efficiency of the track and minimise HF emissions.

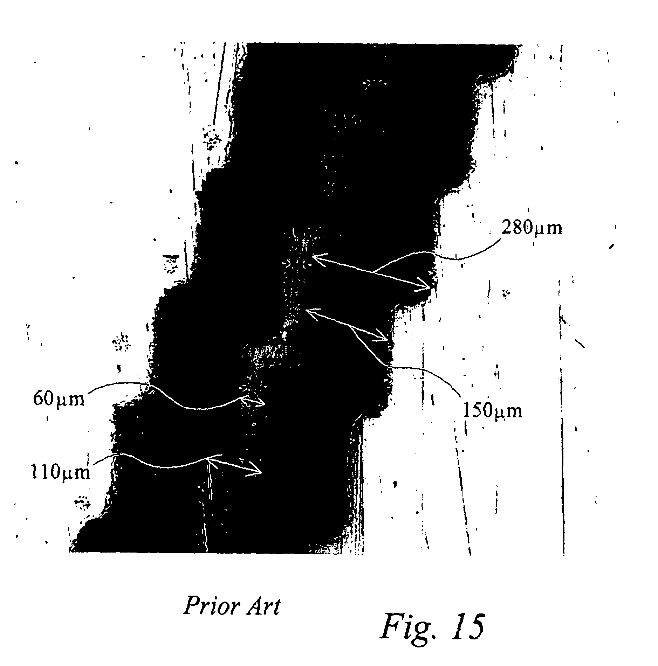

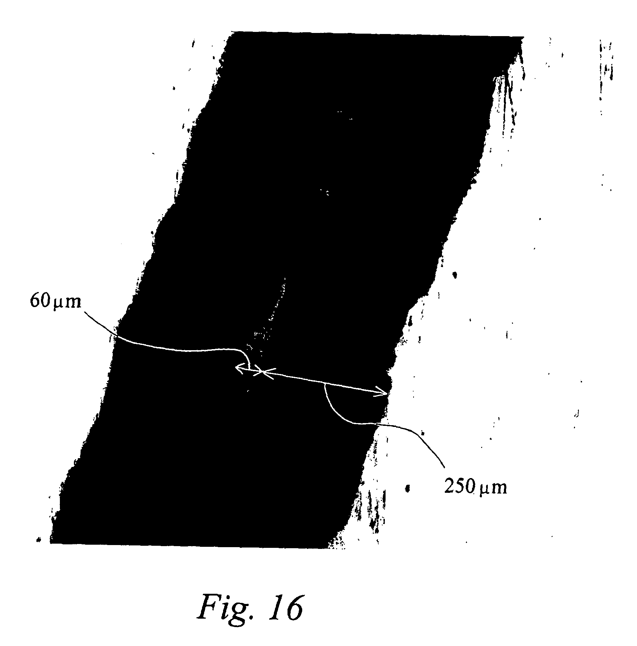

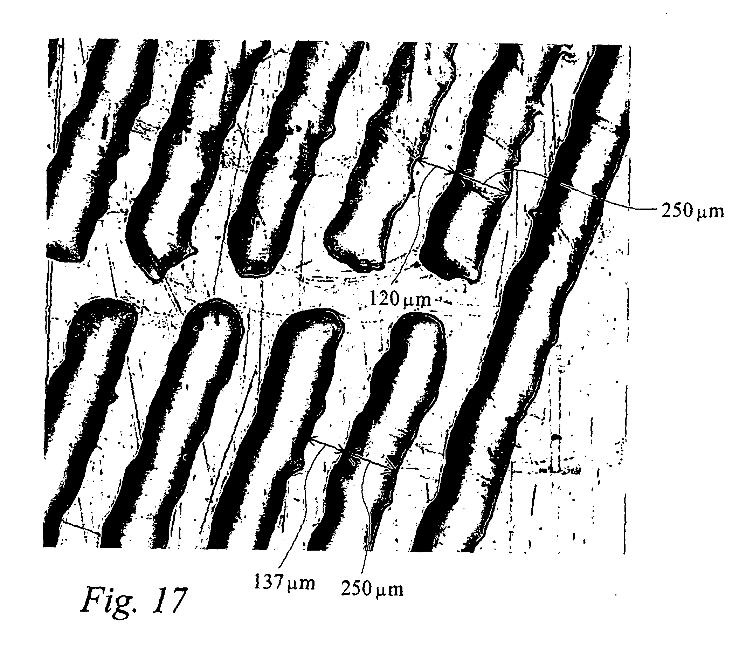

Figures 15 to 17 depict actual images printed by an inkjet print head depositing 4 dot sizes on the substrate. Figure 15 is printed in binary and the tracks have a width ranging between 150 microns and 280 microns. By contrast, Figure 16 is a corresponding track printed via a routine according to the present invention. The track has a more uniform width that that of the track printed in binary. Figure 17 depicts a plurality of tracks printed side by side. The upper tracks have a pitch of 371 $\mu$m, whilst the lower tracks have an inter track spacing of 389$\mu$m.

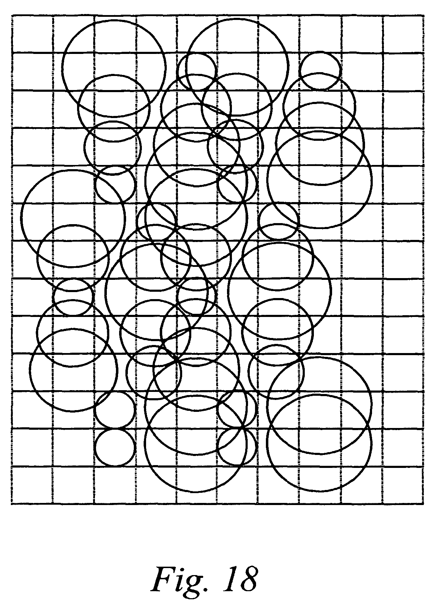

In another aspect of this invention, attention can be focused not upon the tracks themselves but on the gaps between them. In certain applications there will be the need to establish a minimum gap between two tracks, where the track edges are not straight lines. According to this invention, with a set of n dot diameters $D_i = 2s(1/2 + i/n)$, where i is a running integer from 0 to (n-1); pairs of dots are formed at respective sides of the gap at locations spaced by 2s. It is then ensured that the sum of the diameters of the pair of dots equals $2s(2n-1)/n$. This is illustrated in Figure 18, where a track arrangement is formed from a set of five dots having dot diameters:

$D_0 = s$
$D_1 = 1.4s$
$D_2 = 1.8s$
$D_3 = 2.2s$
$D_4 = 2.6s$

It will be seen that at either side of each gap, pairs of dots are formed, with centres spaced by 2s. Only the pairs $D_0/D_4$, $D_1/D_3$ and $D_2/D_2$ are employed. These pairs are characterized in that their diameters sum to s + $D_4$. This can be more generally expressed as 2s(2n-1)/n.

Figure 14 also illustrates the feature that by forming two gaps of the same form closely together, a track can be produced of narrow width and arbitrary form.

It will be understood that this invention has been described by way of examples only and that a wide variety of developments and modifications are possible without departing from the scope of the invention as defined by the claims.

Thus for larger track areas, it may be preferable to use the above-described techniques to define the track edges, with alternative dot structures used to fill in the bulk of the track. Multi-layer printed circuit boards can be formed, with the above-described techniques also used to create interconnecting vias or insulating patterns.

In a further example, conductive tracks can be formed not only by the direct printing techniques that have been described in detail, but also by indirect techniques. Thus the above described techniques can be employed to form an etch mask, used subsequently to form conductive tracks.

Whilst the present invention has been described above with respect to dots printed on a substrate and especially dots printed on a substrate in a single pass of an inkjet print head, other methods of generating the dots are envisaged. The term "track" is not intended to be limited to an electrically conducting track. Other applications in which the present application may also be of benefit are those in which a surface texture or profile is required from a single pass of a print head. Such textures or profiles may be required for artistic purposes or functional purposes e.g. creating bumps for solder, wells for containing other material, pressure pads, separators, or lenses. The invention may also be used in the generation of optical displays or images projected onto a surface. For optical displays, the displays may be static or they may display variable image data. OLEDs or LEDs may display the image.

By forming the same or different arrangements of tracks in repeated layers, three dimensional structures may be constructed.

## Claims

1. A method of forming an arrangement of tracks having defined electrical or mechanical properties, by the deposition of liquid to form dots on a substrate from nozzles mutually spaced by a distance **s**; the method comprising the steps of defining a set of n dot diameters $D_i = 2s(1/2 + i/n)$, where **i** is a running integer from **0** to **(n-1)**; depositing liquid to form linear tracks at one or more directions with respect to an axis **X**; each track having a minimum track width $T_w = s(3n-2)/n$; and the minimum spacing of tracks along the axis **X** being $T_s = s/n$.

2. A method according to Claim 1, wherein the dot diameters: **s, 1.5s, 2s** and **2.5s** are employed.

3. An arrangement of tracks having defined electrical or mechanical properties formed by the deposition of liquid to form dots on a substrate at a regular array of deposition locations mutually spaced by a distance s, the dots having a set of n dot diameters $D_i = 2s(1/2 + i/n)$, where **i** is a running integer from **0** to **(n-1)**; the arrangement comprising linear tracks orientated at orientations with respect to an axis **X**, at least one track having a track width $T_w = s(3n-2)/n$; and at least two tracks having a mutual spacing $T_s$ along the axis **X** of $T_s = s/n$.

4. An arrangement according to Claim 3, wherein the dot diameters: **s, 1.5s, 2s** and **2.5s** are employed.

5. A method of forming a linear track having defined electrical or mechanical properties by the deposition of liquid to form dots on a substrate from nozzles mutually spaced by a distance **s**, the track being inclined to an axis **X**; the method comprising the steps of defining a set of at least three dot diameters $D_i$ where the smallest dot diameter $D_{min} = s$ and the largest diameter $D_{max} = 3s$ ; and repeatedly forming a dot pattern comprising at least three dots in a line parallel to the axis **X**, the first and third of these dots being of diameters which are equal and which are less than the diameter of the second dot, each succeeding repetition of the dot pattern being offset from the preceding pattern a distance **s** in the direction orthogonal to the direction **X** and a distance equal to or greater than s in the direction **X**.

6. A method according to Claim 5, wherein the set comprises **n** dot diameters $D_i = 2s(1/2 + i/n)$, where **i** is a running integer from **0 to (n-1)**.

7. A method according to Claim 6, wherein the dot pattern takes the form at one angle of:

$$D_0, D_1, D_2, \ldots D_i, \ldots D_{n-1}, \ldots D_i, \ldots D_2, D_1, D_0$$

with dots in the pattern being progressively removed for increasing angles and dots in the pattern being progressively repeated for decreasing angles.

8. A linear track having defined electrical or mechanical properties formed by the deposition of liquid to form dots on a substrate at a regular array of deposition locations mutually spaced by a distance s, the track being inclined to an axis **X;** the track comprising a repeated dot pattern comprising at least three dots in a line parallel to the axis **X,** the first and third of these dots being of diameters which are equal and which are less than the diameter of the second dot, each succeeding repetition of the dot pattern being offset from the preceding pattern a distance **s** in the direction orthogonal to the direction **X** and a distance equal to or greater than **s** in the direction **X.**

9. A track according to Claim 8, wherein the set comprises **n** dot diameters $D_1 = 2s(1/2 + i/n)$, where **i** is a running integer from **0 to (n-1)**.

10. A track according to Claim 9, wherein the dot pattern takes the form at one angle of:

$$D_0, D_1, D_2, ... D_l, ...D_{n-1}, ... D_1, ... D_2, D_1, D_0$$

with dots in the pattern being progressively removed for increasing angles and dots in the pattern being progressively repeated for decreasing angles.

11. A substrate having formed thereon at least one track having defined electrical or mechanical properties formed by the deposition of liquid to form dots on a substrate at a regular array of deposition locations mutually spaced by a distance **s**, the track having an edge being inclined to an axis **X**; the track edge comprising a repeated dot pattern comprising at least three dots in a line parallel to the axis **X**, the diameters of the dots increasing along the line, each succeeding repetition of the dot pattern being offset from the preceding pattern a distance **s** in the direction orthogonal to the direction **X** and a distance equal to or greater than **s** in the direction **X**.

12. A method of defining a gap between two planar structures having defined electrical or mechanical properties by the deposition of liquid to form dots on a substrate at a regular array of deposition locations mutually spaced by a distance **s**, parallel to an axis **X**; the method comprising the steps of defining a set of n dot diameters $D_i = 2s(1/2 + i/n)$, where **i** is a running integer from **0** to (**n-1**); forming pairs of dots at respective sides of the gap at locations spaced by **2s**; the sum of the diameters of the pair of dots equalling **2s(2n-1)/n.**

13. A method of forming a track, said method comprising the steps: assigning a grid of addressable pixels to a substrate, said grid having a predetermined spacing **s**, where **s** is a distance; selecting for each pixel a dot of one of **n** predetermined sizes, wherein **n** is an integer greater than **2**; forming the dots on the substrate and thereby forming the track; wherein at least **one of the predetermined sizes of dots has a diameter greater than s = 2**.

14. A method according to Claim 13, wherein the diameter is not less than **2s**.

15. A method according to Claim 13 or Claim 14, wherein the predetermined size of a dot for each pixel is selected such that a straight-line track edge is approximated by said dots to within **s/n**.

16. A method according to Claim 13, wherein the edge lies at an angle to the axis of the addressable grid.

17. A method according to Claim 13, wherein a structure is formed from a plurality of layers and wherein each layer has a respective edge corresponding to the track edge.

18. A method of approximating a straight track edge on a substrate, said track edge being approximated by a plurality of dots, each dot having one of **n** diameters, where **n** is greater than **2**; said method comprising the steps: assigning a grid of addressable pixels to a substrate, said grid having a predetermined spacing **s**; calculating the position of said profile with respect to said addressable pixels; determining for each addressable pixel whether a portion of profile adjacent or within a pixel would be better approximated by a dot in said pixel or by a dot in a neighbouring pixel; and displaying a dot in said determined pixel.

19. Method according to Claim 18, wherein at least one of the n diameters of dots is greater than **s = 2**.

20. Method according to Claim 18, wherein at least one of the n diameters of dots is not less than **2s**.

21. Method according to any one of Claim 18 to Claim 20, wherein at least one dot is displayed in a neighbouring pixel which is not an adjacent pixel.

22. Method according to any one of Claims 18 to 21, wherein the dots approximate the track edge to within s/n.

23. A track arrangement on a substrate, said arrangement comprising two groups of dots, said dots being arranged in a plurality of addressable pixels, the addressable pixels have an inter dot spacing, measured from the centre of a pixel to the centre of an adjacent pixel of **s**; wherein the dots of each group overlap and each dot has one of **n** diameters, wherein **n** is an integer greater than **2** ; wherein each group has an edge approximated by said dots; wherein the distance between the two edges is of the order **s/n**.

**Patentansprüche**

1. Verfahren zur Bildung einer Anordnung von Bahnen mit festgelegten elektrischen oder mechanischen Eigenschaften, durch die Aufbringung von Flüssigkeit zwecks Bildung von Punkten auf einem Substrat ausgehend von Düsen, die voneinander eine Strecke s beabstandet sind; das Verfahren umfassend die Schritte des Festlegens einer Gruppe von n Punktdurchmessern $D_i$ = 2s(1/2 + i/n), mit **i** als einer fortlaufenden Ganzzahl von **0** bis **(n-1)**; und des Aufbringens von Flüssigkeit zwecks Bildung linearer Bahnen in einer oder mehreren Richtungen in Bezug auf eine Achse **X**; wobei jede Bahn eine minimale Bahnbreite $T_w$ = s(3n-2)/n aufweist; und die minimale Beabstandung von Bahnen entlang der Achse **X** $T_s$ = s/n ist.

2. Verfahren nach Anspruch 1, wobei die Punktdurchmesser: **s, 1,5s, 2s** und **2,5s** verwendet werden.

3. Anordnung von Bahnen mit festgelegten elektrischen oder mechanischen Eigenschaften, gebildet durch die Aufbringung von Flüssigkeit zwecks Bildung von Punkten auf einem Substrat in einer regelmäßigen Anordnung von Aufbringungsstellen, die voneinander eine Strecke **s** beabstandet sind, wobei die Punkte eine Gruppe von **n** Punktdurchmessern $D_i$ = 2s(1/2 + **i/n**) aufweisen, mit **i** als einer fortlaufenden Ganzzahl von **0** bis **(n-1);** wobei die Anordnung lineare Bahnen umfasst, die in Ausrichtungen in Bezug auf eine Achse **X** orientiert sind, zumindest eine Bahn eine Bahnbreite $T_w$ = **s(3n-2)/n** aufweist; und zumindest zwei Bahnen eine gegenseitige Beabstandung $T_s$ entlang der Achse **X** von $T_s$ = **s/n** aufweisen.

4. Anordnung nach Anspruch 3, wobei die Punktdurchmesser: **s, 1,5s, 2s** und **2,5s** verwendet werden.

5. Verfahren zur Bildung einer linearen Bahn mit festgelegten elektrischen oder mechanischen Eigenschaften durch die Aufbringung von Flüssigkeit zwecks Bildung von Punkten auf einem Substrat ausgehend von Düsen, die voneinander eine Strecke **s** beabstandet sind, wobei die Bahn zu einer Achse **X** geneigt ist; das Verfahren umfassend die Schritte des Festlegens einer Gruppe von zumindest drei Punktdurchmessern $D_i$, mit dem kleinsten Punktdurchmesser $D_{min}$ = **s** und dem größten Durchmesser $D_{max}$ = **3s**; und des wiederholten Bildens eines Punktmusters, das zumindest drei Punkte in einer Linie parallel zur Achse **X** umfasst, wobei der erste und der dritte dieser Punkte Durchmesser aufweisen, die gleich sind und die kleiner sind als der Durchmesser des zweiten Punkts, wobei jede nachfolgende Wiederholung des Punktmusters versetzt ist gegenüber dem vorhergehenden Muster um eine Strecke **s** in der zur Richtung **X** orthogonalen Richtung und um eine Strecke gleich oder größer s in Richtung **X**.

6. Verfahren nach Anspruch 5, wobei die Gruppe **n** Punktdurchmesser $D_i$ = **2s(1/2 + i/n)** umfasst, mit **i** als einer fortlaufenden Ganzzahl von **0** bis **(n-1).**

7. Verfahren nach Anspruch 6, wobei das Punktmuster bei einem Winkel die Form annimmt von:

$$D_0, D_1, D_2, ... D_i, ... D_{n-1}, ... D_i, ... D_2, D_1, D_0$$

wobei Punkte im Muster progressiv entfernt werden für zunehmende Winkel und Punkte im Muster progressiv wiederholt werden für abnehmende Winkel.

8. Lineare Bahn mit festgelegten elektrischen oder mechanischen Eigenschaften, gebildet durch die Aufbringung von Flüssigkeit zwecks Bildung von Punkten auf einem Substrat in einer regelmäßigen Anordnung von Aufbringungsstellen, die voneinander eine Strecke **s** beabstandet sind, wobei die Bahn zu einer Achse **X** geneigt ist; die Bahn umfassend ein wiederholtes Punktmuster mit zumindest drei Punkten in einer zur Achse **X** parallelen Linie, wobei der erste und der dritte dieser Punkte Durchmesser aufweisen, die gleich sind und die kleiner sind als der Durchmesser des zweiten Punkts, wobei jede nachfolgende Wiederholung des Punktmusters versetzt ist gegenüber dem vorhergehenden Muster um eine Strecke $s$ in der zur Richtung $X$ orthogonalen Richtung und um eine Strecke gleich oder größer $s$ in Richtung $X$.

9. Bahn nach Anspruch 8, wobei die Gruppe $n$ Punktdurchmesser $D_i = 2s(1/2 + i/n)$ umfasst, mit $i$ als einer fortlaufenden Ganzzahl von $0$ bis $(n-1)$.

10. Bahn nach Anspruch 9, wobei das Punktmuster bei einem Winkel die Form annimmt von:

$$D_0, D_1, D_2, ... D_i, ... D_{n-1}, D_i, ... D_2, D_1, D_0$$

wobei Punkte im Muster progressiv entfernt werden für zunehmende Winkel und Punkte im Muster progressiv wiederholt werden für abnehmende Winkel.

11. Substrat, auf dem zumindest eine Bahn mit festgelegten elektrischen oder mechanischen Eigenschaften geformt ist, gebildet durch die Aufbringung von Flüssigkeit zwecks Bildung von Punkten auf einem Substrat in einer regelmäßigen Anordnung von Aufbringungsstellen, die voneinander eine Strecke $s$ beabstandet sind, wobei die Bahn einen zu einer Achse $X$ geneigten Rand aufweist; der Bahnrand umfassend ein wiederholtes Punktmuster mit zumindest drei Punkten in einer zur Achse $X$ parallelen Linie, wobei die Durchmesser der Punkte entlang der Linie zunehmen, wobei jede nachfolgende Wiederholung des Punktmusters versetzt ist gegenüber dem vorhergehenden Muster um eine Strecke $s$ in der zur Richtung $X$ orthogonalen Richtung und um eine Strecke gleich oder größer $s$ in Richtung $X$.

12. Verfahren zur Festlegung einer Lücke zwischen zwei planaren Strukturen mit festgelegten elektrischen oder mechanischen Eigenschaften durch die Aufbringung von Flüssigkeit zwecks Bildung von Punkten auf einem Substrat in einer regelmäßigen Anordnung von Aufbringungsstellen, die voneinander eine Strecke $s$ beabstandet sind, parallel zu einer Achse $X$; das Verfahren umfassend die Schritte des Festlegens einer Gruppe von $n$ Punktdurchmessern $D_i = 2s(1/2 + i/n)$, mit $i$ als einer fortlaufenden Ganzzahl von $0$ bis $(n-1)$; und das Bilden von Punktpaaren an jeweiligen Seiten der Lücke an Stellen, die $2s$ beabstandet sind; wobei die Summe der Durchmesser des Punktpaars gleich $2s(2n-1)/n$ ist.

13. Verfahren zur Bildung einer Bahn, wobei das Verfahren die Schritte umfasst: Zuordnen eines Rasters adressierbarer Pixel zu einem Substrat, wobei das Raster ein vorbestimmtes Rastermaß $s$ aufweist, mit $s$ als einer Strecke; Auswählen für jedes Pixel eines Punkts mit einer von $n$ vorbestimmten Größen, wobei $n$ eine Ganzzahl größer als $2$ ist; Bilden der Punkte auf dem Substrat und **dadurch** Bilden der Bahn; wobei zumindest **eine der vorbestimmten Größen von Punkten einen Durchmesser größer als $s = 2$ aufweist**.

14. Verfahren nach Anspruch 13, wobei der Durchmesser nicht kleiner ist als $2s$.

15. Verfahren nach Anspruch 13 oder Anspruch 14, wobei die vorbestimmte Größe eines Punkts für jedes Pixel so ausgewählt ist, dass sich die Punkte einem geradlinigen Bahnrand bis innerhalb $s/n$ annähern.

16. Verfahren nach Anspruch 13, wobei der Rand in einem Winkel zur Achse des adressierbaren Rasters liegt.

17. Verfahren nach Anspruch 13, wobei eine Struktur aus einer Mehrzahl von Schichten gebildet wird und wobei jede Schicht einen jeweiligen Rand aufweist, der dem Bahnrand entspricht.

18. Verfahren zur Annäherung an einen geraden Bahnrand auf einem Substrat, wobei sich dem Bahnrand eine Mehrzahl von Punkten annähert, wobei jeder Punkt einen von $n$ Durchmessern aufweist, mit $n$ größer als $2$; wobei das Verfahren die Schritte umfasst: Zuordnen eines Rasters adressierbarer Pixel zu einem Substrat, wobei das Raster ein vorbestimmtes Rastermaß $s$ aufweist; Berechnen der Position des Profils in Bezug auf die adressierbaren Pixel; Bestimmen für jedes adressierbare Pixel, ob einem Profilabschnitt angrenzend an oder innerhalb eines Pixels besser ein Punkt in dem Pixel oder ein Punkt in einem benachbarten Pixel angenähert würde; und Anzeigen eines Punkts in dem bestimmten Pixel.

19. Verfahren nach Anspruch 18, wobei zumindest einer der $n$ Durchmesser von Punkten größer ist als $s = 2$.

**20.** Verfahren nach Anspruch 18, wobei zumindest einer der **n** Durchmesser von Punkten nicht kleiner ist als **2s**.

**21.** Verfahren nach einem der Ansprüche 18 bis 20, wobei zumindest ein Punkt in einem benachbarten Pixel angezeigt wird, das nicht ein angrenzendes Pixel ist.

**22.** Verfahren nach einem der Ansprüche 18 bis 21, wobei sich die Punkte dem Bahnrand bis innerhalb **s/n** annähern.

**23.** Bahnanordnung auf einem Substrat, wobei die Anordnung zwei Gruppen von Punkten umfasst, die Punkte in einer Mehrzahl adressierbarer Pixel angeordnet sind, die adressierbaren Pixel eine Zwischen-Punkt-Strecke aufweisen, gemessen von der Mitte eines Pixels zur Mitte eines angrenzenden Pixels mit **s**; wobei sich die Punkte jeder Gruppe überlappen und jeder Punkt einen von **n** Durchmessern aufweist, wobei **n** eine Ganzzahl größer als **2** ist; wobei jede Gruppe einen Rand aufweist, dem sich die Punkte annähern; wobei die Strecke zwischen den beiden Rändern in der Größenordnung **s/n** liegt.

## Revendications

**1.** Procédé permettant de former un système de traces ayant des propriétés électriques ou mécaniques définies par le dépôt de liquide pour former des points sur un substrat à partir de buses espacées les unes des autres par une distance s ; le procédé comprenant les étapes consistant à : définir un ensemble de n diamètres de points $D_i = 2s(1/2 + i/n)$, i étant un nombre entier glissant de 0 à (n-1) ; déposer un liquide pour former des traces linéaires dans une ou plusieurs directions par rapport à un axe X ; chaque trace ayant une largeur de trace minimum $T_w = s(3n-2)/n$ ; et l'espace minimum entre des traces sur l'axe X étant $T_s = s/n$.

**2.** Procédé selon la revendication 1, dans lequel les diamètres de points: s, 1,5s, 2s et 2,5s sont employés.

**3.** Système de traces ayant des propriétés électriques ou mécaniques définies, formé par le dépôt de liquide pour former des points sur un substrat au niveau d'un ensemble régulier de positions de dépôt qui sont espacées les unes des autres par une distance s, les points ayant un ensemble de n diamètres de points $D_i = 2s(1/2 + i/n)$, i étant un nombre entier glissant de 0 à (n-1) ; le système comprenant des traces linéaires orientées à des orientations par rapport à un axe X, au moins une trace ayant une largeur de trace $T_w = s(3n-2)/n$ ; et au moins deux traces ayant un espace $T_s$ entre elles sur l'axe X, de $T_s = s/n$.

**4.** Système selon la revendication 3, dans lequel les diamètres de points : s, 1,5s, 2s et 2,5s sont employés.

**5.** Procédé permettant de former une trace linéaire ayant des propriétés électriques ou mécaniques définies par le dépôt de liquide pour former des points sur un substrat à partir de buses espacées les unes des autres par une distance s, la trace étant inclinée par rapport à un axe X ; le procédé comprenant les étapes consistant à : définir un ensemble d'au moins trois diamètres de points $D_i$, le diamètre de points le plus petit $D_{min}$ étant égal à s, et le diamètre de points le plus grand $D_{max}$ étant égal à 3s ; et à former à plusieurs reprises un motif de points comprenant au moins trois points sur une ligne parallèle à l'axe X, le premier et le troisième de ces points étant de diamètres qui sont égaux et qui sont inférieurs au diamètre du deuxième point ; chaque répétition successive du motif de points étant décalée par rapport au motif précédent d'une distance s dans la direction orthogonale à la direction X, et d'une distance qui est égale ou supérieure à s dans la direction X.

**6.** Procédé selon la revendication 5, dans lequel l'ensemble comprend n diamètres de points $D_i = 2s(1/2 + i/n)$, i étant un nombre entier glissant de 0 à (n-1).

**7.** Procédé selon la revendication 6, dans lequel le motif de points prend la forme à un angle de :

$$D_0, D_1, D_2, ... D_i, ... D_{n-1}, ... D_i, ... D_2, D_1, D_0$$

des points dans le motif étant progressivement éliminés pour des angles en augmentation, et des points dans le motif étant progressivement répétés pour des angles en diminution.

**8.** Trace linéaire ayant des propriétés électriques ou mécaniques définies par le dépôt de liquide pour former des points sur un substrat au niveau d'un ensemble régulier de positions de dépôt qui sont espacées les unes des autres par une distance s, la trace étant inclinée par rapport à un axe X ; la trace comprenant un motif de points répété comprenant au moins trois points sur une ligne parallèle à l'axe X, le premier et le troisième de ces points étant de diamètres qui sont égaux et qui sont inférieurs au diamètre du deuxième point ; chaque répétition successive du motif de points étant décalée par rapport au motif précédent d'une distance s dans la direction orthogonale à la direction X, et d'une distance qui est égale ou supérieure à s dans la direction X.

9. Trace selon la revendication 8, dans laquelle l'ensemble comprend n diamètres de points $D_i = 2s(1/2 + i/n)$, i étant un nombre entier glissant de 0 à (n-1).

10. Trace selon la revendication 9, dans lequel le motif de points prend la forme à un angle de :

$$D_0, D_1, D_2, ... D_i, ... D_{n-1}, ... D_i, ... D_2, D_1, D_0$$

des points dans le motif étant progressivement éliminés pour des angles en augmentation, et des points dans le motif étant progressivement répétés pour des angles en diminution.

11. Substrat ayant, formée sur lui, au moins une trace linéaire ayant des propriétés électriques ou mécaniques définies par le dépôt de liquide pour former des points sur un substrat au niveau d'un ensemble régulier de positions de dépôt qui sont espacées les unes des autres par une distance s, la trace ayant un bord qui est incliné par rapport à un axe X ; le bord de la trace comprenant un motif de points répété comprenant au moins trois points sur une ligne parallèle à l'axe X, les diamètres des points augmentant le long de la ligne ; chaque répétition successive du motif de points étant décalée par rapport au motif précédent d'une distance s dans la direction orthogonale à la direction X, et d'une distance qui est égale ou supérieure à s dans la direction X.

12. Procédé permettant de définir un espace entre deux structures planaires ayant des propriétés électriques ou mécaniques définies par le dépôt de liquide pour former des points sur un substrat au niveau d'un ensemble régulier de positions de dépôt qui sont espacées les unes des autres par une distance s, parallèlement à un axe X ; le procédé comprenant les étapes consistant à : définir un ensemble de n diamètres de points $D_i = 2s(1/2 + i/n)$, i étant un nombre entier glissant de 0 à (n-1) ; former des paires de points au niveau de côtés respectifs de l'espace au niveau de positions qui sont espacées par une distance 2s ; la somme des diamètres de la paire de points étant égale à $2s(2n-1)/n$.

13. Procédé permettant de former une trace, ledit procédé comprenant les étapes consistant à : attribuer une grille de pixels adressables à un substrat, ladite grille ayant un espace prédéterminé s, s étant une distance ; sélectionner, pour chaque pixel, un point de l'une des n tailles prédéterminées, n étant un nombre entier plus grand que 2 ; former les points sur le substrat, et former de ce fait la trace ; au moins une des tailles prédéterminées de points ayant un diamètre plus grand que s = 2.

14. Procédé selon la revendication 13, dans lequel le diamètre n'est pas plus petit que 2s.

15. Procédé selon la revendication 13 ou la revendication 14, dans lequel la taille prédéterminée d'un point pour chaque pixel est sélectionnée de telle sorte que le bord d'une trace en ligne droite est lissé par lesdits points à l'intérieur de s/n.

16. Procédé selon la revendication 13, dans lequel le bord se situe à un angle par rapport à l'axe de la grille adressable.

17. Procédé selon la revendication 13, dans lequel une structure est formée à partir d'une pluralité de couches, et dans lequel chaque couche a un bord respectif correspondant au bord de la trace.

18. Procédé de lissage du bord d'une trace en ligne droite sur un substrat, ledit bord de trace étant lissé par une pluralité de points, chaque point ayant l'un de n diamètres, n étant plus grand que 2 ; ledit procédé comprenant les étapes consistant à : attribuer une grille de pixels adressables à un substrat, ladite grille ayant un espace prédéterminé s ; calculer la position dudit profil par rapport auxdits pixels adressables ; déterminer, pour chaque pixel adressable, si une partie d'un profil adjacent ou à l'intérieur d'un pixel serait mieux lissé par un point dans ledit pixel ou par un point dans un pixel voisin ; et afficher un point dans ledit pixel déterminé.

19. Procédé selon la revendication 18, dans lequel au moins un des n diamètres de points est plus grand que s = 2.

20. Procédé selon la revendication 18, dans lequel au moins un des n diamètres de points n'est pas plus petit que 2s.

**21.** Procédé selon l'une quelconque des revendications 18 à 20, dans lequel au moins un point est affiché dans un pixel voisin qui n'est pas un pixel adjacent.

**22.** Procédé selon l'une quelconque des revendications 18 à 21, dans lequel les points lissent le bord de la trace à l'intérieur de s/n.

**23.** Système de traces sur un substrat, ledit système comprenant deux groupes de points, lesdits points étant agencés dans une pluralité de pixels adressables, les pixels adressables ayant un espace inter-points, mesuré depuis le centre d'un pixel jusqu'au centre d'un pixel adjacent, qui est égal à s ; dans lequel les points de chaque groupe se chevauchent, et chaque point a l'un de n diamètres, n étant un nombre entier plus grand que 2 ; dans lequel chaque groupe a un bord lissé par lesdits points ; dans lequel la distance entre les deux bords est de l'ordre de s/n.

*Prior Art*

*Fig. 1*

*Prior Art*

*Fig. 2*

*Fig. 3*

*Fig. 4*

EP 1 719 394 B1

*Fig. 5*

19

Fig. 6

EP 1 719 394 B1

*Fig. 7*

*Fig. 8A*

*Fig. 8B*

*Fig. 8C*

*Fig. 8D*

*Prior Art*

*Fig. 9A*

*Fig. 9B*

*Fig. 9C*

*Fig. 9D*

Fig. 10A

Fig. 10B

Fig. 10C

Fig. 10D

*Fig. 11A*

*Fig. 11B*

*Fig. 11C*

Fig. 12A

error

4

Fig. 12B

error

Fig. 12C

*Fig. 13*

*Fig. 14*

*Fig. 15*

*Prior Art*

280μm

150μm

60μm

110μm

*Fig. 16*

60 μm

250 μm

EP 1 719 394 B1

*Fig. 17*

*Fig. 18*